# EUROPEAN PATENT APPLICATION

(11) **EP 1 533 853 A2**
(43) Date of publication of application: **25.05.2005**
(21) Application number: 04027421.9
(22) Date of filing: 18.11.2004
(51) Int. Cl.: H01L 51/20, G02B 6/00

(54) **Lighting device**

(30) Priority: 24.11.2003 JP 2003435333
(71) Applicant: Kabushiki Kaisha Toyota Jidoshokki, Kariya-shi, Aichi-ken (JP)
(72) Inventor: Takeuchi, Norihito, K.K.Toyota Jidoshokki, Kariya-shi Aichi-ken (JP)
(74) Representative: Leson, Thomas Johannes Alois, Dipl.-Ing.

(57) **Abstract**

A lighting device having an electroluminescent device formed on an incident surface of a transparent substrate. The lighting device is **characterized by** a light emitting surface opposite to the incident surface being formed larger than said light emitting surface, and a light redirecting member disposed at least in a portion of said transparent substrate that is not associated with said electroluminescent device, wherein light which enters through said incident surface into said transparent substrate and proceeds toward a direction in which the light does not exit from said light emitting surface is redirected by said light redirecting member to exit from said light emitting surface.

## Description

The present invention relates to a lighting device having an electroluminescent device (hereinafter referred to as "EL device") formed on the light incident surface of a transparent substrate.

A lighting device or an electroluminescent panel (hereinafter referred to as an "EL panel") which includes the EL device formed over the transparent substrate is conventionally known. The use of a lighting device for backlighting a display device, such as a liquid crystal display device is also known.

An organic EL panel is provided with an organic EL device in which an anode, an organic electroluminescent layer ("electroluminescent layer" is hereinafter referred to as "EL layer") and a cathode which has light reflecting property are laminated in this order on a transparent substrate. The anode is formed from a light transmissive conductive material such as indium tin oxide (hereinafter referred to as "ITO"). When the organic EL device is in a light emitting state, the light is emitted from the transparent substrate side.

While there is a need that the organic EL device is formed into a large area, the yield of the organic EL device decreases due to difficulty of uniformly forming an organic EL layer over a large area because the thickness of the organic EL device is extremely thin, with the thickness of the organic EL layer in a range between several tens to several hundreds of nanometers.

Japanese Patent Laid-Open Publication 2001-52858 discloses a large area display device or a large area organic EL panel manufactured by forming a cell comprising a single unit of the organic EL device and arranging a plurality of the cells.

However, when the large area organic EL panel is formed by arranging a plurality of the organic EL devices having small areas, the areas between adjacent organic EL devices decreases the luminous of the organic EL panel. Each organic EL device requires a terminal electrode and an electrode connection line for connecting the anode and the cathode to an external driver circuit. The terminal electrodes and the electrode connection lines are disposed in the periphery of the organic EL devices. The area where the terminal electrode and the electrode connection line are formed appears dark since the light does not transmit therethrough although the organic EL device emits light. In this way, in a large area organic EL panel formed by arranging a plurality of organic EL devices, the areas between adjacent organic EL devices appear dark.

On the other hand, the light which entered the transparent substrate needs to be emitted with high efficiency from a surface opposite to a surface facing the EL devices (hereinafter referred to as a "light emitting surface"), in order to efficiently use the light emitted from the organic EL devices. However, since the light emitted from the organic EL devices is radiated into various directions, the incident angle of the light to the light emitting surface also can be various values. Further, the generally used transparent substrates have higher refractive indices than that of the external atmosphere (generally air).

Accordingly, the incident light on the transparent substrate includes light which does not exit from the emitting surface but exits directly from an end face of the transparent substrate, which is emitted from the end face after being totally reflected on the light emitting surface and guided through the transparent substrate and which is attenuated after entering into the organic EL layer. In other words, an organic EL panel using the organic EL device has a significant amount of light that is not utilized for illumination.

The present invention is devised in view of the above described problems. An object of the invention is to provide a lighting device which uses the EL device for a light source and is capable of irradiating light from an area larger than the area of the EL layer, by using light that has not been used effectively in the conventional art.

In order to achieve the above, a lighting device having an electroluminescent device formed on an incident surface of a transparent substrate is provided. The lighting device is characterized by a light emitting surface opposite to the incident surface being formed larger than said light emitting surface, and a light redirecting member disposed at least in a portion of said transparent substrate that is not associated with said electroluminescent device, wherein light which enters through said incident surface into said transparent substrate and proceeds toward a direction in which the light does not exit from said light emitting surface is redirected by said light redirecting member to exit from said light emitting surface. Note that the term "transparent" used herein denotes a property which transmits at least visible rays. The examples of the light redirecting member are a light scattering member and a light reflecting member.

Since the area of the light emitting surface is formed larger than the area of the light emitting member of the EL device, a portion of the light entering the transparent substrate from the EL device is guided through the portions not associated with the EL device of the transparent substrate. Among the light proceeding to the portion not associated with the EL device, the majority part of the light, which did not exit from the light emitting surface in the conventional and, is redirected by the light redirecting member to exit from the light emitting surface. Accordingly, the portion of the light that could not be used in the conventional art is emitted from the part of the light emitting surface that are not associated with the EL devices to let the light exit from a larger area than the area of the EL layer.

In one aspect, the light redirecting member is disposed only in a portion which is not associated with the EL devices. Since the light redirecting portion is not disposed in the portion of the transparent substrate associated with the EL device, the light that is incident on the light emitting surface with an angle no more than the critical angle can only be emitted from the light emitting surface among the light entering from the EL device.

In one aspect of the invention the light redirecting member comprises a light reflecting member at least on the surface opposite to the light emitting surface. Note that through the specification the term "light reflecting member" denotes a member which is capable of allowing the light guided through the transparent substrate with an angle to the light emitting surface larger than the critical angle to reflect and to alter the proceeding direction of the light with a smaller angle than the critical angle. Note that the angle to the light emitting surface denotes an angle formed between the direction of the light and the direction normal to the light emitting surface.

In this case, since the light incident on the surface opposite to the light emitting surface is reflected by the light reflecting member, at least a portion of the reflected light is emitted from the light emitting surface. Accordingly, the luminosity emitted from the light emitting surface can be higher compared to the case where the surface opposite to the light emitting surface is a light absorbing surface or a light transmissive surface.

In another aspect the light reflecting member comprises a plurality of grooves that forming a light extracting surface which allows light that is guided through said portion of said transparent substrate to reflect to exit from said light emitting surface. In this case, the light proceeding toward the end face of the transparent substrate is reflected on the light extracting surface while it is guided through the portion that is not associated with the EL device. The direction of the light is then changed to direct to a direction vertical to the light emitting surface to be emitted from the light emitting surface. The reflected light is emitted from the light emitting surface with higher efficiency in this way compared to the case where the light reflecting member is a flat surface.

In another aspect the light redirecting member comprises a light scattering member. In this case, the light transmitted through the portion that is not associated with the EL device toward an end face of the substrate, or the light that proceeds to be incident on the light emitting surface to have an angle no less than the critical angle, is scattered at the light scattering member to change the direction of the light. The luminosity of the emitted light can thus be increased.

In another aspect the light scattering member is formed on the light emitting surface. In this case, at least a portion of the light that is not capable of exiting from the light emitting surface if the light emitting surface is a flat surface because the light is subjected to total reflection and is incident on the light emitting surface with an angle which does not allow the light to exit, can be emitted from the light emitting surface. Accordingly, the luminosity of the light emitted from the light emitting surface can be increased.

In another aspect the transparent substrate is formed to have a thickness that decreases as the location increases in distance from the portion that is associated with the EL device. In this case, the light from the light emitting surface can be sufficiently emitted in the portion that is not associated with the EL device compared to a transparent substrate having uniform thickness.

In one aspect the EL device is an organic EL device. In this case, the light source can be illuminated at a lower voltage compared to the case where an inorganic EL device is used.

According to the invention, light can be irradiated from a larger area than the area of the EL layer by using light that cannot be efficiently used in the conventional art.

The invention, together with objects and advantages thereof, may best be understood by reference to the following description of the presently preferred embodiments together with the accompanying drawings in which:
FIG. 1 schematically shows a cross section of a lighting device according to a first embodiment;
FIG. 2 is a schematic plan view of the lighting device of the first embodiment;
FIG. 3 is a schematic cross sectional view of a lighting device according to a second embodiment;
FIG. 4 is a schematic plan view of the lighting device of the second embodiment;
FIG. 5 schematically shows the operation of the light extracting surface;
FIG. 6 schematically shows a cross section of a lighting device according to a third embodiment;
FIG. 7 schematically shows a cross section of a lighting device according to a fourth embodiment; and
FIG. 8 schematically shows a cross section of a lighting device according to yet another embodiment.

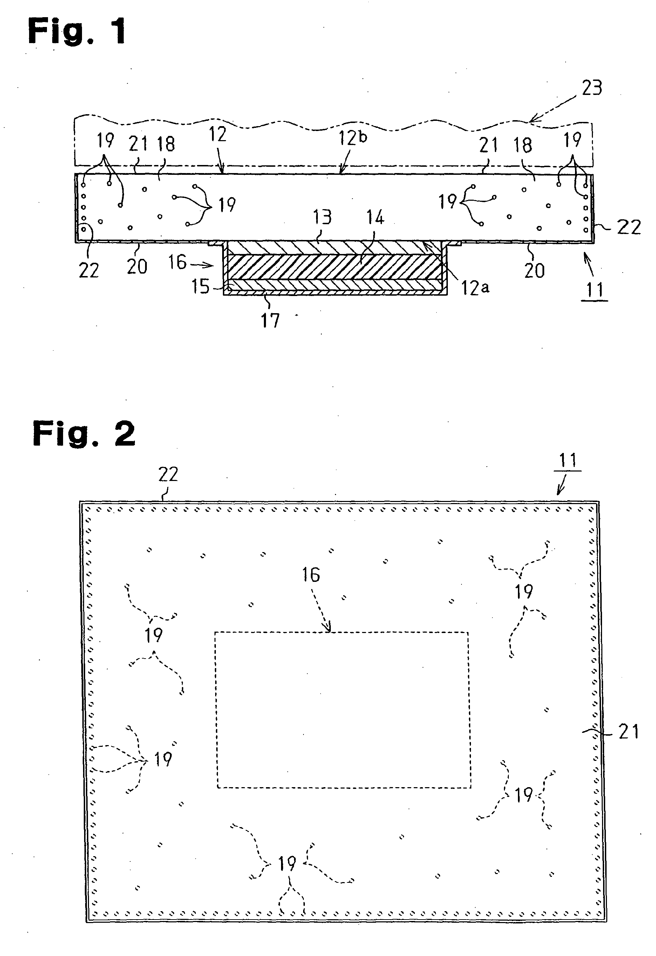

Referring to FIGs. 1 and 2, a first embodiment of the invention that exemplifies a lighting device provided with an organic EL device is described below. FIG. 1 schematically shows a cross section of a lighting device according to the first embodiment. FIG. 2 is a schematic plan view of the lighting device of the first embodiment.

As shown in FIG. 1, the lighting device 11 includes a first electrode 13, an organic EL layer 14 and a second electrode 15 formed in this order on a surface of a transparent substrate 12. The first electrode 13, the organic EL layer 14 and the second electrode 15 form an organic EL device 16. The organic EL device 16 is covered by a passivation film 17 in order to prevent the organic EL layer 14 from contacting with the external atmosphere. The passivation film 17 is formed from a material that at least functions to prevent permeation of moisture (water vapor) and oxygen. In the first embodiment the passivation film 17 is formed from silicon nitride. The organic EL device 16 is a bottom emission type organic EL device in which the light emitted from the organic EL layer 14 is extracted (emitted) from the transparent substrate 12 side.

The first electrode 13 is formed from a transparent conductive material. In the first embodiment ITO is used as the transparent conductive material. The structure of the organic EL layer 14 can be one of any conventionally known structure. For example, it is configured into a three layer structure of a hole injection layer, an emitting layer and an electron injection layer laminated in this order from the first electrode 13, or a four layer structure of a hole injection layer, a hole transport layer, an emitting layer and an electron transport layer. The organic EL layer 14 is formed to emit white light. When the lighting device 11 is used for backlighting a display, a full-color display can be achieved by using a color filter.

The second electrode 15 is formed from a metal (e.g., aluminum) and has a light reflecting property. In the first embodiment the first electrode 13 forms the anode and the second electrode 15 forms the cathode. By providing a light reflecting property to the second electrode 15, the luminosity obtained from the light emitting surface 12b can be increased.

The transparent substrate 12 in the first embodiment is formed from a glass substrate. The transparent substrate 12 includes an incident surface 12a provided with the organic EL device 16 and a light emitting surface 12b opposite to the incident surface 12a. The area of the light emitting surface 12b is larger than the area of the organic EL layer 14, which is an emitting portion of the organic EL device 16. As shown in FIG. 2, the transparent substrate 12 and the organic EL device 16 of the first embodiment are formed into a rectangular shape in which the organic EL device 16 is disposed in the central region of the transparent substrate 12.

A non-associative portion 18, which is a region that is not associated with the organic EL device 16, is provided with a light redirecting member for redirecting the light that is incident on the incident surface 12a and transmitted through the transparent substrate 12 toward a direction with an angle to the light emitting surface 12b larger than the critical angle on the light emitting surface 12b, to allow emitting from the light emitting surface 12b. In the first embodiment light scattering members 19 and 21 are disposed for the light redirecting member.

The light scattering members 19 are disposed within the transparent substrate 12 and are provided with a surface which scatters the light. Used herein, the term "scatter" denotes reflection or refraction.

The light scattering members 19 of the first embodiment comprises marks formed by laser irradiation or a portion of the transparent substrate that has a different refraction index than the surroundings. There is no limitation to the shape of the light scattering members 19 so that a shape which enables high light extraction efficiency can be appropriately designed. For example as shown in FIG. 1, they can be formed into a spherical shape or a shape that has a circular cross section. In this way, when the light scattering members 19 have rounded surfaces on the periphery (surface), light entering from the same direction can be scattered into various directions depending on the position of light incidence.

The positions of the light scattering members 19 can be appropriately designed to have high light extracting efficiency. For example, the light scattering members 19 can be either disposed to randomly distribute light when observed from the light emitting surface 12b side or disposed to randomly distribute light when viewed from the side face side (as shown in FIG. 1). Further, the light scattering members 19 can be disposed to randomly distribute light when viewed from any direction.

The light scattering members 19 are not necessarily arranged to randomly distribute light in the thickness of the non-associative portion 18 (in a direction normal to the light emitting surface 12b). They can be arranged for example, denser in the proximity of the light emitting surface 12b, denser in the proximity of the surface opposite to the light emitting surface 12b or denser in the core portion of the substrate. The light scattering members 19 can be arranged to have higher density in the peripheral portion of the transparent substrate 12 compared to other portions of the substrate.

The light scattering members 19 of the first embodiment are arranged to have higher density in the peripheral portion of the transparent substrate 12 compared to other portions, where the members are arranged randomly.

Since the light scattering members 19 are formed denser in the peripheral portion of the transparent substrate 12, light which did not encounter light scattering members 19 in the central portion of the substrate is capable of being emitted from the light emitting surface 12b by hitting light scattering members 19 disposed in the peripheral portion. Accordingly, the luminosity of light emitted from the light emitting surface 12b can be averaged compared to the case where the density of the light scattering members 19 decreases in the peripheral portion or the members 19 are provided uniformly through the entire substrate.

The light scattering portions 19 are formed through methods for providing markings (laser marking method) inside of the transparent substrate. For example, when the light scattering members 19 are formed through the device and method disclosed in Japanese Patent Laid-Open 2001-276985, a pulsed laser having high output is condensed at a portion inside the transparent material such as glass so that energy absorption occurs at the portion due to the non-linear optical effect by the application of the intense optical electric field. Accordingly, damage, a refractive index change and density change occur only in the vicinity of the focal point so that the inner portions can be processed without affecting the surface of the material. In other words, the light scattering members 19 can be formed in the prescribed positions within the transparent substrate 12 by positioning the transparent substrate 12 on a stage which is movable in X, Y and Z directions and by repeating the condensing operation of the laser irradiation at the prescribed positions and the displacement operation of the stage in the X, Y and Z directions.

An Nd-YAG laser can be used for example as the laser source. Pulsed laser enables marking with excellent controllability and pulsed laser having short pulse width is preferable because the depth of the marking can be set uniformly. For this reason, a laser source using pulses below a subnanosecond time scale, for example, a femtosecond laser having pulse width on the order of 10⁻¹⁵ second can be advantageous.

The timing for forming the light scattering members 19 on the transparent substrate 12 can be either before or after forming the organic EL device 16, or it can be even while performing the process steps of the organic EL device 16, for example after forming the first electrode 13.

Since the light scattering members 19 can be selectively formed in the focal points of the laser, the light scattering members 19 can be formed in the prescribed positions without damaging the surface of the transparent substrate 12. The degree of freedom in the design and the process is high with this method because there is less limitation to the shape and arrangement of the light scattering members 19.

Further, since the light scattering portions 19 can be formed in the steps later than the formation of the organic EL device 16, it is possible to avoid formation of the light scattering members 19 when the organic EL device 16 is a failure or defective.

The light scattering members 21 disposed on the light emitting surface 12b of the non-associative portion 18 are formed by roughening the light emitting surface 12b. The roughening can be done, for example through a sandblasting process.

Light reflecting surfaces 20 and 22 are formed on the surface opposite to the light emitting surface 12b of the non-associative portion 18 and the end faces of the transparent substrate 12. A metal film having a light reflecting property is formed in the first embodiment. The surface opposite to the light emitting surface 12b of the non-associative portion 18 can therefore be a reflecting surface. Aluminum can be used for the metal having a light reflecting property.

Note that while FIG. 1 schematically shows the constitutions, the thickness of the first electrode 13, the organic EL layer 14 and the second electrode 15 are in fact approximately in the range of several tens to one thousand nanometers while the thickness of the transparent substrate 12 is about in a range between 0.5 and 1 mm. The thickness of the passivation film 17 is formed no less in thickness than those of the first electrode 13, the organic EL layer 14 and the second electrode 15, however, the scale of each constitution is shown differently from the actual scale for convenience of illustration in the drawing. The size of the transparent substrate 12 and the organic EL device 16 are also shown differently from the actual scale. Further, hatching of the transparent substrate 12 is omitted in the figures.

The operation of the lighting device 11 thereby formed is next described. The lighting device 11 can be used for a light source for backlighting disposed on the reverse side (opposite side of the display) of a transmissive type liquid crystal panel 23 (shown in FIG. 1 by a chain line).

When electric power to the lighting device 11 is supplied, the voltage is applied between the first electrode 13 and the second electrode 15 to emit light from the organic EL layer 14. The light emitted from the organic EL layer 14 enters the transparent substrate 12 by way of the first electrode 13. Among the light which entered the transparent substrate 12, the light emitted from the light emitting surface 12b toward the liquid crystal panel 23 is effectively used for illumination light of the lighting device 11. The operator of the liquid crystal display device sees the display on the liquid crystal panel 23 by the emitted light.

When the light scattering members 19 are not provided, the light that proceeds in a direction having an angle with respect to the light emitting surface 12b larger than the critical angle will not be emitted from the light emitting surface 12b. The incident angle on the light emitting surface 12b of such light will not be changed even though the light is thereafter subjected to total reflection on the light emitting surface 12b, reflection on the end faces of the transparent substrate 12, or reentering the organic EL device 16. The light is thereby emitted from the end face of the transparent substrate 12 or attenuated in the inside of the transparent substrate 12 or the organic EL device 16. Note that when a non-alkali glass having a refractive index of approximately 1.51 is used for the transparent substrate 12, the critical angle θc between the atmosphere having a refractive index approximately 1.00 will be approximately 42 degrees as provided by the equation for the critical angle, θc = sin⁻¹(1/1.51).

On the other hand, since the light emitted by the organic EL device 16 is irradiated in various directions, the incident angle on the transparent substrate 12 from the organic EL device 16 also can be various values. Accordingly, only a portion of the light emitted from the organic EL device 16 and entering into the transparent substrate 12 is emitted to the outside from the lighting device 11 through the light emitting surface 12b associated with the organic EL device 16. Accordingly, the majority part of the light entering the transparent substrate 12 can not be used efficiently when a conventional device is used that has a light emitting surface 12b only at regions associated with the organic EL device 16.

The lighting device of the first embodiment guides the light that is not emitted from the region of the light emitting surface 12b associated with the organic EL device 16 through the non-associative portion 18. Since the light scattering members 19 are provided in the non-associative portion 18, the light is scattered to change its direction when the guided (transmitted) light encounters the light scattering members 19. Among the light whose direction is changed at the light scattering members 19, a portion of the light is redirected to have an incident angle with respect to the light emitting surface 12b smaller than the critical angle so that the light is emitted toward the liquid crystal panel 23 through the light emitting surface 12b. The light which is redirected at the light scattering members 19 in the direction opposite to the light emitting surface 12b is directed to the light reflecting surface 20, transmitted to the light emitting surface 12b, and emitted from the light emitting surface 12b.

The light that is transmitted with an incident angle with respect to the light emitting surface 12b larger than the critical angle, without encountering the light scattering members 19 while it is guided through the non-associative portion 18 is subjected to total reflection on the light entering surface 12b to return into the non-associative portion 18. The light that reached the end faces of the transparent substrate 12 without encountering the light scattering member 19 is reflected on the light reflecting surface 22 and is guided through the non-associative portion 18 again. Some portion of the light that has been accordingly redirected into the non-associative portion 18 encounters the light scattering member 19 while it is guided through the non-associative portion 18 so that it is emitted from the light emitting surface 12b due to the operation of the light scattering members 19 and the light reflecting surface 20 as already described. Therefore, the light entering the transparent substrate 12 from the organic EL device 16 can be effectively used by providing the non-associative portion 18.

The first embodiment provides the light scattering portions 21, which are formed by roughening the light emitting surface 12b in the non-associative portion 18. Thus, some portion of the light incident on the light emitting surface 12b with an incident angle that can cause total reflection when the surface is not roughened, is prevented from total reflection so that it is emitted from the light emitting surface 12b.

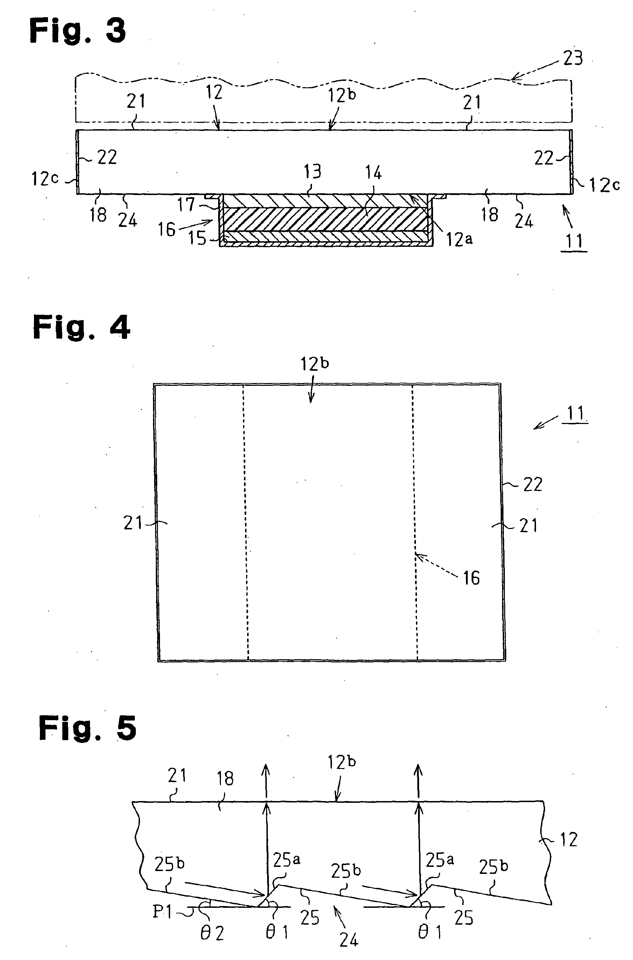

The second embodiment of the invention is described next by referring to FIGs. 3-5. The illumination of the second embodiment is distinctive from the first embodiment in that the light scattering members 19 are not provided in the non-associative portion 18 and that the light reflecting member 24 is disposed on a side opposite to the light emitting surface 12b in the non-associative portion 18. Other constitutions are similar to that of the first embodiment. Accordingly, the light reflecting member 24 of the second embodiment acts as the light redirecting member.

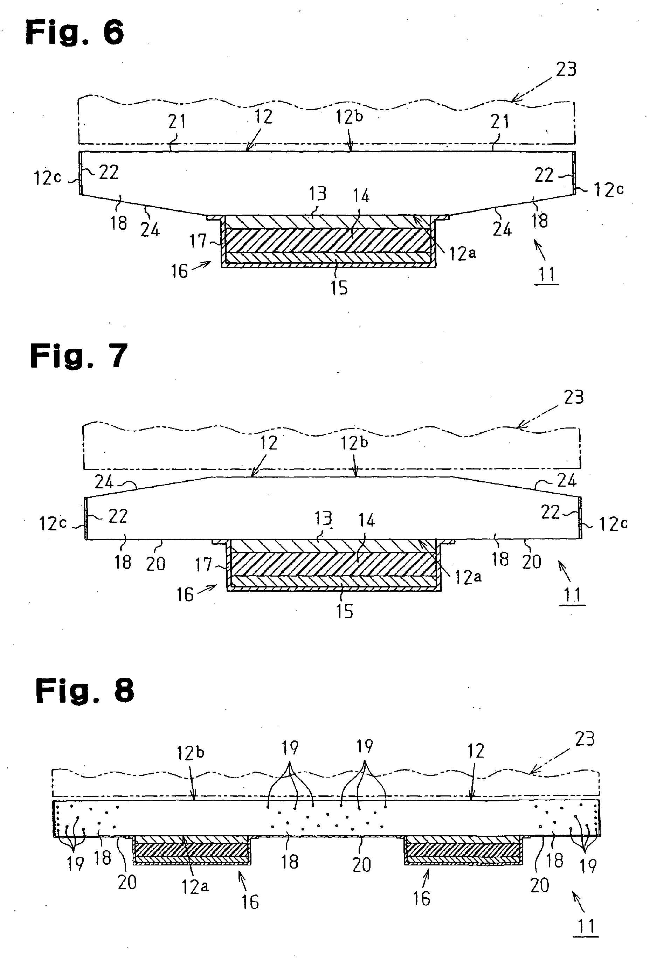

Similar reference numerals are applied to the constitutions similar to those of the first embodiment and detailed descriptions are omitted. FIG. 3 is a schematic cross sectional view of the lighting device, FIG. 4 is a schematic plan view of the lighting device and FIG. 5 is a schematic showing the operation of the light extracting surface.

As shown in FIGs. 3 and 4, the transparent substrate 12 is formed into a rectangular shape and the non-associative portions 18 are provided on both sides in the longitudinal direction. While the light scattering members 21 are disposed on the surface of the non-associative portions 18, the light scattering members are not disposed inside the transparent substrate 12. The light reflecting member 24 is disposed on the side opposite to the light emitting surface 12b in the non-associative potions 18.

As shown in FIG. 5, a plurality of grooves 25 which form the light extracting surfaces 25a are formed on the light reflecting member 24 to reflect the light which is transmitted through the non-associative portion 18 in the direction from the surface opposite to the organic EL device 16 toward the end face 12c to direct to the light emitting surface 12b. In the second embodiment the grooves 25 are formed in parallel. The grooves 25 are formed to extend in parallel to the end face 12c (in the normal direction to the page of FIG. 5).

In each of the grooves 25 a light extracting surface 25a and a light guiding surface (inclined surface) 25b are alternatively arranged. With the light emitting surface 12b side of the transparent substrate 12 assumed to be the upper side, the light extracting surface 25a is inclined upwards directing light from the organic EL device 16 to the end face 12c. The light guiding surface 25b is inclined downwards, directing light from the surface opposite to the organic EL device 16 to the end face 12c.

In other words, the grooves 25 are formed in parallel and appear as peaks or serrations in the cross section taken along the longitudinal direction of the transparent substrate 12. Note that FIG. 5 shows a portion of the light reflecting member 24 which is formed in the non-associative portion 18 shown in the right hand side of the organic EL device 16 in FIG. 3. Accordingly, the end face 12c would exist in the extension in the right hand side. When the light reflecting member 24 is disposed in the left hand side of the organic EL device 16, the inclination of the light extracting surface 25a and the light guiding surface 25b will be symmetrical to those of the right hand side.

The light extracting surface 25a is formed to cause total reflection of the light which is guided through the non-associative portion 18 toward the end face 12c and reaches the light extracting surface 25a, to the direction substantially perpendicular to the light emitting surface 12b. As shown in FIG. 5, the groove 25 is formed so that the light extracting surface 25a has an angle θ1 to the light extracting surface 25a and a plane P1 parallel to the light emitting surface 12b in a range between, for example, 35 to 40 degrees, preferably between 40 and 45 degrees. An angle θ2 of the light guiding surface 25b and the plane P1 is for example in the range between 0.3 and 2.5 degrees. While a number of grooves 25 are formed with a pitch of 1 mm or less, these grooves are omitted in FIGs. 3 and 4.

As shown in FIG. 5, in the lighting device 11 of the second embodiment, the light guided through the non-associative portion 18 toward the end face 12c and reaching the light extracting surface 25a is subjected to total reflection in the direction of the light emitting surface 12b with approximately a vertical angle with respect to the plane P1 to emit the light from the emitting surface 12b. The light guided through the non-associative portion 18 toward the end face 12c is not always transmitted straight forward to the light extracting surface 25a. Some portion of the light reaching the light extracting surface 25a reaches the surface 25a after being reflected on the light guiding surface 25b or the light emitting surface 12b and guided through the non-associative portion 18. Because the light guiding surface 25b is formed to incline downward to the end face 12c, the light not directly reflected toward the light extracting surface 25a can be repeatedly guided so that the light is gradually directed in the parallel direction to the plane P1. Accordingly, the light can be efficiently reflected on the light extracting surface 25a to the light emitting surface 12b with an angle almost perpendicular with respect to the plane P1.

In this way, the light being guided through the non-associative portion 18 in the direction of the end face 12c can be emitted efficiently from the light emitting surface 12b even though the light scattering members 19 are not disposed within the non-associative portion 18.

The third embodiment is described by referring FIG. 6. In the third embodiment the transparent substrate 12 is not a plate having a uniform thickness. The third embodiment is distinctive from the second embodiment in that the thickness of the non-associative portion 18 is formed to be thinner as the distance from the portion associated with the organic EL device 16 increases. Other constitutions are similar to those of the second embodiment. Namely, the light scattering portion 21, which is formed by roughening the light emitting surface 12b, with the light reflecting member 24 is formed on the side opposite to the light emitting surface 12b, and the light scattering member 21 and the light reflecting member 24 act as the light redirecting member. Note that the light scattering members 19 are not disposed. The grooves 25 are omitted in FIG. 6. Here, the thickness of the non-associative portion 18 becomes thinner when it is viewed macroscopically. Strictly speaking the thickness is gradually decreased with slight increase and decrease because the surface provided with the light reflecting member 24 has a serrated shape.

The light guided through the non-associative portion 18 toward the end face 12c is emitted from the light emitting surface 12b by way of the light extracting surface 25a and the light guiding surface 25b also in the third embodiment, similarly to the case of the second embodiment.

Because the surface provided with the light reflecting member 24 is formed to incline toward the light emitting surface 12b and departs from the portion associated with the organic EL device 16, it is easier to obtain uniform luminosity emitted from the light emitting surface 12b compared to the case where the distance between the light reflecting member 24 and the light emitting surface 12b is constant.

The fourth embodiment is described by referring FIG. 7. In the fourth embodiment, the thickness of the transparent substrate 12 becomes thinner when viewed from a macroscopic perspective similarly to the third embodiment. However, the placement of the light reflecting member 24 differs from that of the third embodiment. The transparent substrate 12 is formed flat on the incident surface 12a side, and the light emitting surface 12b of the non-associative portion 18 is macroscopically inclined toward the surface opposite to the light emitting surface 12b as it departs from the portion associated with the organic EL device 16. Accordingly, the light redirecting member comprises the light reflecting surface 20 and the light reflecting member 24.

The light reflecting member 24 has grooves 25 (not shown in the figure) disposed on the non-associative portion 18 of the light emitting surface 12b. The light reflecting surface 20, which is similar to that of the first embodiment, is disposed on the surface opposite the light emitting surface 12b in the non-associative potion 18. The light reflecting member 24 is formed to cause total reflection of the light reaching the light extracting surface 25a after being guided through the non-associative potion 18 toward the end face 12c with an angle almost perpendicular with respect to the light reflecting surface 20.

In the fourth embodiment among the light entering the transparent substrate 12, the light guided toward the end face 12c is reflected toward the light reflecting surface 20 with an angle almost perpendicular, by means of the light extracting surface 25a and the light guiding surface 25b of the light reflecting member 24. The light is then reflected perpendicularly to the light reflecting surface 20 on the light reflecting surface 20 to exit from the light emitting surface 12b.

Because the light emitting surface 12b provided with the light reflecting member 24 is formed to incline toward the surface opposite to the light emitting surface 12b and departs from the portion associated with the organic EL device 16, it is easier to obtain uniform luminosity emitted from the light emitting surface 12b compared to the case where the distance between the light reflecting member 24 and the light emitting surface 12b is constant.

It should be apparent to those skilled in the art that the present invention may be embodied in many other specific forms without departing from the spirit or scope of the invention. Particularly, it should be understood that the invention may be embodied in the following forms.

The light scattering portion 19 can be formed into a longitudinal line shape which extends into the direction of thickness of the transparent substrate 12.

The light scattering portion 19 is not limited to those formed by laser marking. The light scattering portion 19 can be configured, for example by dispersing beads which have a refractive index different from that of the transparent substrate 12.

The thickness of the non-associative portion 18 can be formed to decrease as departing from the portion associated with the organic EL device 16, also in the structure that is formed with the light scattering members 19 and the light reflecting surface 20 are provided for the light redirecting members without providing the light reflecting member 24 with a plurality of the grooves 25, as can be found in the first embodiment. When the light redirecting member having the light scattering member 19 and the light reflecting surface 20 is used, the non-associative potion 18 is preferably formed as substantially wedge shaped in which the thickness decreases toward the end face 12c when viewed from a macroscopic perspective.

The quantity of the organic EL devices 16 formed can be more than one. For example, two organic EL devices can be formed as shown in FIG. 8. In this case, it is preferable to dispose the light scattering members 19 and the light reflecting surface 20 rather than providing the light reflecting member 24 for the light redirecting member.

The light reflecting surface 20 disposed opposite to the light emitting surface 12b can be provided with a light scattering member. Accordingly, the light reflecting member 20 is not necessarily a flat mirror like surface, but it can be a reflecting surface in which diffuse reflection is caused.

The light redirecting member can be disposed with a plurality of prism-shaped or lens-shaped projections arranged in parallel, instead of providing the light scattering members 21 disposed on the light emitting surface 12b.

The light scattering members 21 can be omitted from the light emitting surface 12b.

The metal film that acts as the light reflecting surface 22 on the end face of the transparent substrate 12 can be omitted.

When the luminosity emitted from the light emitting surface 12b in the portion associated with the organic EL device 16 is not sufficient, the light scattering member 21 formed by roughening the surface can also be formed in the portion associated with the organic EL device 16.

The distribution of the light scattering members 19 that form the light redirecting member is not necessarily formed to provide uniform luminosity through the entire light emitting surface 12b and can be formed so that the distribution of luminosity varies.

The organic EL layer 14 is not necessarily formed to emit white light. The layers emitting single colors of red, blue, green or' yellow, or a combination thereof can also be used.

The lighting device 11 can be formed with the diffusing sheet on the light emitting surface 12b of the transparent substrate 12.

The material of the transparent conductive material forming the first electrode 13 is not limited to ITO. Zinc oxide for example can also be used.

It is possible to form the first electrode 13 to be transparent by using an extremely thin metal film instead of using transparent material having conductivity. Here, extremely thin means a thickness below 50 nm, and a thickness in a range between 0.5 and 20 nm is preferable.

It is possible to use the first electrode 13 as the cathode, and the second electrode 15 as an anode. In this case, the structure of the organic EL layer 14 is also altered to correspond with the electrodes. For example, the organic EL layer 14 is formed into a three layered structure of the electron injection layer, the emitting layer and the hole injection layer in this order from the first electrode 13, or a five layered structure of the electron injection layer, the electron transport layer, the emitting layer, the hole transport layer and the hole injection layer laminated in this order from the first electrode 13.

The organic EL layer 14 can be a single layer of the emitting layer, or can be multiple layers in which the emitting layer and one or more of the hole injection layer, hole transport layer, hole injection transport layer, hole blocking layer, electron injection layer, electron transport layer, electron injection transport layer and electron blocking layer are laminated.

In place of a glass substrate, a transparent substrate comprising resin or a flexible transparent resin substrate can be used for the transparent substrate 12. The resin substrate can be lighter in weight compared to glass substrates.

The shape of the transparent substrate 12 is not limited to a rectangular shape. It can be square, triangular, polygonal, such as pentagon or those having more corners, circular, a circular arc, and so forth. The shape of the organic EL device 16 is not limited to a homothetic of the transparent substrate 12. It is possible for example to form a rectangular organic EL device 16 on a circular transparent substrate 12.

The application of the lighting device 11 is not limited to backlighting. It is also possible to use it as other lighting devices or as light sources for display devices.

Inorganic EL devices can also be used in place of the organic EL devices 16.

Therefore, the present examples and embodiments are to be considered as illustrative and not restrictive and the invention is not to be limited to the details given herein, but may be modified within the scope and equivalence of the appended claims.

A lighting device having an electroluminescent device formed on an incident surface of a transparent substrate. The lighting device is **characterized by** a light emitting surface opposite to the incident surface being formed larger than said light emitting surface, and a light redirecting member disposed at least in a portion of said transparent substrate that is not associated with said electroluminescent device, wherein light which enters through said incident surface into said transparent substrate and proceeds toward a direction in which the light does not exit from said light emitting surface is redirected by said light redirecting member to exit from said light emitting surface.

## Claims

1. A lighting device having an electroluminescent device formed on an incident surface of a transparent substrate, **characterized by** a light emitting surface opposite to the incident surface being formed larger than said light emitting surface, and a light redirecting member disposed at least in a portion of said transparent substrate that is not associated with said electroluminescent device, wherein light which enters through said incident surface into said transparent substrate and proceeds toward a direction in which the light does not exit from said light emitting surface is redirected by said light redirecting member to exit from said light emitting surface.

2. The lighting device according to claim 1 **characterized by** said redirecting member disposed only in the portion of said transparent substrate that is not associated with said electroluminescent device.

3. The lighting device according to claim 1 or 2 **characterized by** said redirecting member comprising a light reflecting means for reflecting light disposed at least on a surface opposite said light emitting surface.

4. The lighting device according to any one of claims 1 to 3 **characterized by** said light reflecting means comprising a plurality of grooves which form a light extracting surface which allows light that is guided through a portion of said transparent substrate that is associated with said electroluminescent device to be reflected to exit from said light emitting surface.

5. The lighting device according to any one of claims 1 to 4 **characterized by** said light redirecting member comprising a light scattering portion.

6. The lighting device according to any one of claims 1 to 5 **characterized by** said light redirecting member comprising a light scattering portion which is formed on said light emitting surface.

7. The lighting device according to any one of claims 1 to 6 **characterized by** the thickness of said transparent substrate decreasing in a portion of said transparent substrate that is associated with said electroluminescent device toward an edge of said substrate.

8. The lighting device according to any one of claims 1 to 7 **characterized by** said electroluminescent device being an organic electroluminescent device.
